# EUROPEAN PATENT APPLICATION

(11) **EP 4 716 445 A2**
(43) Date of publication of application: **25.03.2026**
(21) Application number: 25202110.0
(22) Date of filing: 15.09.2025
(51) Int. Cl.: H10P 72/00

(54) **SUBSTRATE PROCESSING APPARATUS AND CONTROL METHOD**

(30) Priority: 24.09.2024 JP 2024165267
(71) Applicant: SCREEN Holdings Co., Ltd., Kyoto-shi, Kyoto 602-8585 (JP)
(72) Inventor: KASHIYAMA, Masahito, Kyoto, 602-8585 (JP)
(74) Representative: Kilian Kilian & Partner mbB

(57) **Abstract**

A substrate processing apparatus includes: plurality of diverging pipes (PW) formed by branching of a merging pipe downstream of a pump (15) and configured to deliver processing liquid to a plurality of types of processing units in a chamber (41); and a control unit (139) configured to control the pump (15). The plurality of diverging pipes (PW) include a pre-wet pipe (PW) having a largest flow rate of processing liquid and a pot-rinse pipe (PTR) having a flow rate of processing liquid smaller than the flow rate of the pre-wet pipe (PW), a pressure sensor configured to detect a pressure of processing liquid is provided in the pre-wet pipe (PW) among the plurality of diverging pipes (PW), and the control unit (139) controls an output of a pump (15) to allow the pressure sensor (51) to detect a predetermined value.

## Description

### Background of the invention

The present invention relates to a substrate processing apparatus including a chamber for performing liquid processing on a substrate in a horizontal orientation, and a control method of the substrate processing apparatus. The substrate is, for example, a semiconductor wafer, a substrate for a liquid crystal display, a substrate for organic electroluminescence (El), a substrate for a flat panel display (FPD), a substrate for an optical display, a substrate for a magnetic disk, a substrate for an optical disk, a substrate for a magneto-optical disk, a substrate for a photomask, or a substrate for a solar cell.

### Description of the Related Art

JP 2017-69346 A describes an organic solvent supply source of a substrate processing apparatus. The organic solvent supply source includes a pump, and is configured to supply an organic solvent to a nozzle at a predetermined pressure at all times. The nozzle injects the organic solvent fed from the organic solvent supply source toward a substrate in a horizontal orientation.

### <List of documents>

JP 2017-69346 A

However, according to the configuration described above, when the organic solvent supply source is connected to a plurality of organic solvent supply destinations, there is no means to keep a constant pressure in a pipe connected to a nozzle as the organic solvent supply destination. A pressure of the organic solvent applied to the nozzle changes depending on a use situation of the organic solvent at the organic solvent supply destination. That is, in the substrate processing apparatus, when a single nozzle alone uses the organic solvent, the pressure of the organic solvent applied to the nozzle becomes sufficiently high, and appropriate substrate processing can be performed. Whereas, in the substrate processing apparatus, when a plurality of nozzles use a lot of organic solvent at the same timing, the pressure of the organic solvent applied to the nozzles decreases, which disables appropriate substrate processing. Accordingly, unevenness occurs in the substrate processing using the organic solvent in the substrate.

The present invention has been made in view of such a circumstance, and an object thereof is to provide a substrate processing apparatus capable of reliably performing substrate processing. Another object of the present invention is to provide a control method of the substrate processing apparatus for performing reliable substrate processing.

### Summary of the invention

The present invention has the following configuration in order to solve the above-described problem. That is, a substrate processing apparatus according to the present invention includes:
a chamber configured to perform liquid processing on a substrate in a horizontal orientation;
a tank configured to store processing liquid;
a main pipe configured to allow processing liquid to flow from the tank;
a pump provided on the main pipe and configured to feed processing liquid;
a plurality of diverging pipes formed by branching of the main pipe downstream of the pump, and configured to deliver processing liquid to a plurality of types of processing units in the chamber; and
a control unit configured to control the pump,
in which the plurality of diverging pipes include a first diverging pipe having a largest flow rate of processing liquid and a second diverging pipe having a flow rate of processing liquid smaller than the flow rate of the first diverging pipe,
a pressure gauge configured to detect a pressure of processing liquid is provided in the first diverging pipe among the plurality of diverging pipes, and
the control unit controls an output of a pump to allow the pressure gauge to detect a predetermined value.

[Operation and Effect] According to the configuration described above, the liquid processing apparatus includes the pressure gauge provided in the first diverging pipe and configured to detect a pressure of liquid, and the control unit configured to control the pump. The first diverging pipe has a large flow rate of processing liquid, the second diverging pipe has a small flow rate of processing liquid, and the control unit controls an output of the pump to allow the pressure gauge to detect a predetermined value. Even when a pressure of liquid in the first diverging pipe decreases due to an increase in flow of the liquid in the second diverging pipe, the output of the pump is increased to compensate for the decrease. Since the first diverging pipe requires a large amount of liquid, a high pressure is always required in the first diverging pipe. The configuration described above is a configuration that satisfies such a requirement, and the chamber can perform substrate processing under appropriate conditions. With such a configuration, the substrate processing can be reliably executed.

In the configuration described above,
the first diverging pipe is preferably connected to a nozzle that discharges processing liquid onto an upper surface of a substrate in the chamber.

[Operation and Effect] According to the configuration described above, the first diverging pipe is connected to the nozzle that discharges processing liquid to an upper surface of a substrate in the chamber. The configuration described above allows processing liquid to be supplied at an appropriate pressure to the nozzle requiring a large amount of processing liquid in the chamber.

In the configuration described above, the second diverging pipe is preferably a back-rinse pipe for cleaning a substrate back surface in the chamber.

[Operation and Effect] According to the configuration described above, the second diverging pipe is the back-rinse pipe for cleaning a substrate back surface in the chamber. As a result, a pressure applied to the nozzle provided in the first diverging pipe does not change depending on the presence or absence of back-rinse processing. With such a configuration, the substrate processing can be reliably executed.

In the configuration described above,
the second diverging pipe is preferably a pot-rinse pipe for nozzle cleaning in the chamber.

[Operation and Effect] According to the configuration described above, the second diverging pipe is the pot-rinse pipe for nozzle cleaning in the chamber. As a result, a pressure applied to the nozzle provided in the first diverging pipe does not change depending on the presence or absence of pot-rinse processing. With such a configuration, the substrate processing can be reliably executed.

In the configuration described above,
the second diverging pipe is preferably an edge-rinse pipe for cleaning a substrate peripheral edge in the chamber.

[Operation and Effect] According to the configuration described above, the second diverging pipe is the edge-rinse pipe for cleaning a substrate peripheral edge in the chamber. As a result, a pressure applied to the nozzle provided in the first diverging pipe does not change depending on the presence or absence of edge-rinse processing. With such a configuration, the substrate processing can be reliably executed.

In the configuration described above, the second diverging pipe preferably includes a regulator configured to reduce a pressure of liquid.

[Operation and Effect] According to the configuration described above, since an amount of liquid flowing through the second diverging pipe can be reduced, unnecessary consumption of liquid can be reduced.

The present invention is particularly suitable for a substrate processing apparatus including a plurality of chambers.

[Operation and Effect] In a substrate processing apparatus including a plurality of chambers, a first diverging pipe and a second diverging pipe often allow liquid to flow at the same time. Specifically, for example, a case is exemplified in which liquid processing with liquid flowing through the second diverging pipe is performed in the second chamber while processing using the first diverging pipe is performed in the first chamber. When the plurality of chambers are provided as described above, the pressure in the first diverging pipe is likely to decrease. Even in the substrate processing apparatus having such a configuration, substrate processing can be executed without the decrease of the pressure of the liquid in the first diverging pipe.

In addition, the present invention is suitable for a substrate processing apparatus in which the first diverging pipe is located downstream of the second diverging pipe.

[Operation and Effect] In the substrate processing apparatus in which the first diverging pipe is located downstream of the second diverging pipe, in particular, a pressure of the first diverging pipe is likely to decrease due to a flow of liquid in the second diverging pipe. According to the present invention, since the pressure of the first diverging pipe can be reliably made constant by feedback control, such a problem does not occur.

This specification also discloses the following invention.

A control method of a substrate processing apparatus including: a chamber configured to perform liquid processing while rotating a substrate in a horizontal orientation; a tank configured to store liquid; a main pipe configured to allow liquid to flow from the tank to the chamber; a pump provided on the main pipe and configured to feed liquid; a first diverging pipe and a second diverging pipe formed by branching of the main pipe downstream of the pump; and a pressure gauge provided in the first diverging pipe and configured to detect a pressure of liquid, the control method including:
performing feedback control on the pump based on a detected pressure of liquid.

[Operation and Effect] According to the configuration described above, effects similar to those of the substrate processing apparatus of the present invention are achieved.

According to the present invention, it is possible to provide a substrate processing apparatus capable of reliably performing substrate processing.

### Brief of description of the drawings

FIG. 1 is a plan view for explaining an overall configuration of a substrate processing apparatus according to an embodiment;
FIG. 2 is a piping diagram for explaining a degassing unit and a peripheral configuration thereof according to the embodiment;
FIG. 3 is a cross-sectional view for explaining a degassing mode of a degassing device according to the embodiment;
FIG. 4 is a cross-sectional view for explaining the degassing mode of the degassing device according to the embodiment;
FIG. 5 is a cross-sectional view for explaining a configuration of a foaming device according to the embodiment;
FIG. 6 is a cross-sectional view for explaining a configuration of the foaming device according to the embodiment;
FIG. 7 is a cross-sectional view for explaining a configuration of the foaming device according to the embodiment;
FIG. 8 is a flowchart for explaining an operation of the degassing unit according to the embodiment;
FIG. 9 is a piping diagram for explaining an operation of the degassing unit according to the embodiment;
FIG. 10 is a piping diagram for explaining an operation of the degassing unit according to the embodiment;
FIG. 11 is a piping diagram for explaining an operation of the degassing unit according to the embodiment;
FIG. 12 is a piping diagram for explaining an operation of the degassing unit according to the embodiment;
FIG. 13 is a piping diagram for explaining an operation of the degassing unit according to the embodiment;
FIG. 14 is a piping diagram for explaining an operation of the degassing unit according to the embodiment;
FIG. 15 is a piping diagram for explaining an effect according to the embodiment;
FIG. 16 is a piping diagram for explaining an effect according to the embodiment;
FIG. 17 is a cross-sectional view for explaining a configuration of a degassing device according to one modification of the present invention;
FIG. 18 is a piping diagram for explaining a configuration of a degassing device according to one modification of the present invention;
FIG. 19 is a piping diagram for explaining a configuration of a degassing device according to one modification of the present invention;
FIG. 20 is a plan view for explaining an overall configuration of a substrate processing apparatus according to one modification of the present invention; and
FIG. 21 is a piping diagram for explaining a degassing unit and a peripheral configuration thereof according to one modification of the present invention.

### Description of the preferred embodiments

A degassing device according to the present invention is mounted on, for example, a substrate processing apparatus that processes a semiconductor substrate. Therefore, as a mode for carrying out the present invention, a substrate processing apparatus that performs necessary substrate processing before and after exposure processing in a photolithography step will be described as an example.

### Embodiment

### <1. Overall Configuration>

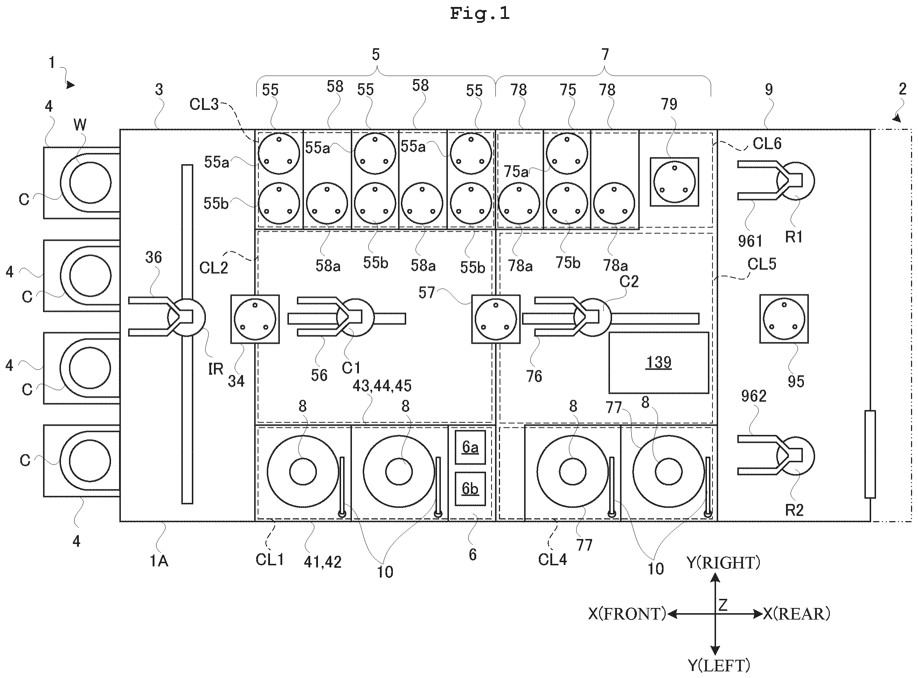

FIG. 1 is a plan view illustrating an overall configuration of a substrate processing apparatus of the present example. A substrate processing apparatus 1 of the present example is connected to an exposure machine 2 for exposure, which is an external device. The substrate processing apparatus 1 further includes an indexer block 3, a coater block 5, a developer block 7, and an interface block 9. The indexer block 3, the coater block 5, the developer block 7, and the interface block 9 are arranged in this order to form the substrate processing apparatus 1. The substrate processing apparatus 1 includes a housing 1A that houses each block. The housing 1A has a substantially rectangular shape in plan view. A load port 4 is provided to protrude from a wall surface on one end side of the housing 1A.

In this specification, for convenience, a direction in which the indexer block 3, the coater block 5, the developer block 7, and the interface block 9 in the substrate processing apparatus 1 are arranged is referred to as a front-rear direction (X direction). The X direction extends horizontally. A direction from the coater block 5 toward the indexer block 3 in the substrate processing apparatus 1 is referred to as front. A direction opposite to the front is referred to as rear. A horizontal direction orthogonal to the X direction is referred to as a left-right direction (Y direction). The Y direction is also a direction in which a plurality of load ports 4 are arranged. One side in the Y direction is referred to as a right side for convenience, and a direction opposite to the right side is referred to as a left side. A height direction (Z direction) is orthogonal to both the X direction and the Y direction, and coincides with a vertical direction. In each figure, front, rear, right, left, up, and down are illustrated as appropriate for reference.

### <2. Indexer Block>

As illustrated in FIG. 1, the indexer block 3 includes the load port 4 which is an entrance when a carrier C storing a plurality of substrates W in a horizontal orientation at predetermined intervals in the Z direction is input into the block. The carrier C can be placed in the load port 4.

A plurality of (for example, 25) substrates W are stacked and stored in one carrier C. The carrier C storing the unprocessed substrates W carried into the substrate processing apparatus 1 is first placed in the load port 4.

In the indexer block 3, an indexer robot IR capable of conveying substrates W in the horizontal orientation one by one is disposed. The indexer robot IR can access a pass 34 provided at a boundary between the indexer block 3 and the coater block 5 illustrated in FIG. 1 and can access any of the four load ports 4, and transfers the substrate W between the pass 34 and the carrier C installed in the load port 4. The transfer of the substrate W by the indexer robot IR is achieved by a hand 36.

### <3. Coater block>

The coater block 5 has a configuration in which a photoresist layer is mainly formed on the substrate W before exposure processing. The coater block 5 includes a second row CL2 located on the rear side of the pass 34, a first row CL1 provided on the left side of the second row CL2, and a third row CL3 provided on the right side of the second row CL2. Therefore, the second row CL2 is located at a position sandwiched between the first row CL1 and the third row CL3 from left and right.

In the first row CL1, chemical liquid processing chambers are arranged in the X direction. The chemical liquid processing chamber has a spin chuck 8 that rotatably supports the substrate W, and a nozzle 10 that discharges chemical liquid. Therefore, the chemical liquid processing chamber is configured to apply the chemical liquid to a surface of the substrate W. The chemical liquid processing chamber includes a vacuum chamber 45 for film formation of an antireflection film, and resist chambers 41, 42, 43, and 44 for film formation of a photoresist layer. In the first row CL1 of FIG. 1, a state is described in which two of the resist chambers 41, 42, 43, and 44 or two vacuum chambers 45 are arranged in the front-rear direction. In the first row CL1, the vacuum chamber 45 and the resist chambers 41, 42, 43, and 44 are stacked across three layers. A vertical relationship between the vacuum chamber 45 and the resist chambers 41, 42, 43, and 44 can be appropriately switched. The first row CL1 may have four or more chemical liquid processing chambers. The resist chambers 41, 42, 43, and 44 are configured to apply liquid processing to the substrate W in the horizontal orientation, and correspond to a chamber of the present invention.

An edge exposure unit is provided in the third row CL3 to be described later or a sixth row CL6 in the developer block 7 to be described later. The edge exposure unit can perform edge exposure related to removal of a photoresist layer at a peripheral edge portion of the substrate W.

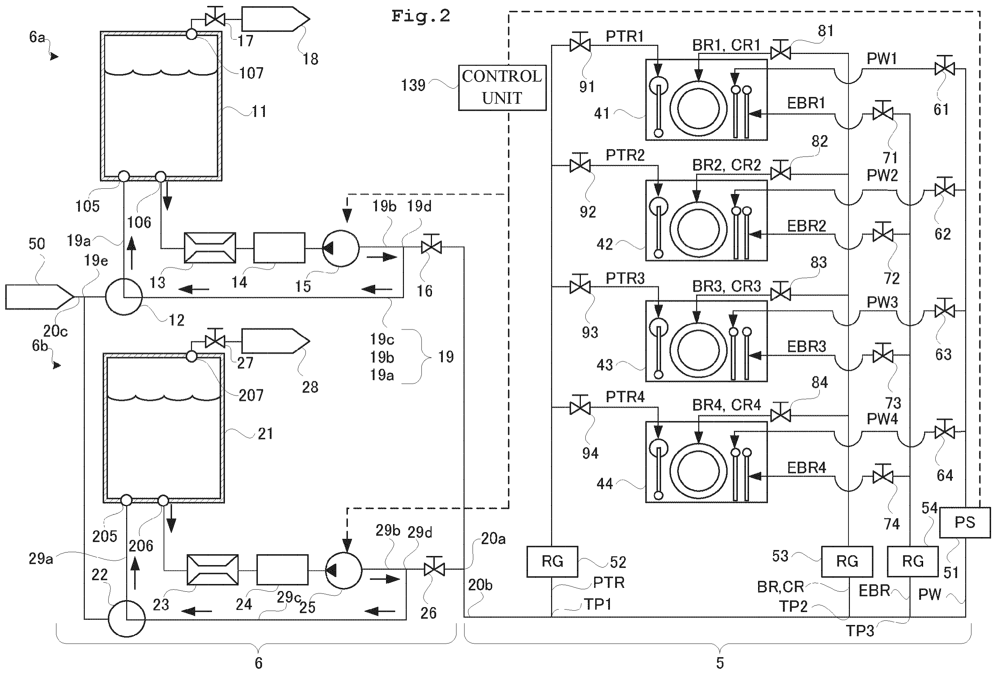

In addition to this, the first row CL1 is provided with a degassing chamber 6 configured to provide a degassed solvent to the resist chambers 41, 42, 43, and 44 and including a first degassing device 6a and a second degassing device 6b. A configuration of the degassing chamber 6 will be described later with reference to FIG. 2. The degassing chamber 6 supplies liquid to the resist chambers 41, 42, 43, and 44 described later. Note that the degassing chamber 6 of the present example can also supply liquid to the vacuum chamber 45.

The second row CL2 is a passage through which a first center robot C1 that conveys the substrate W in the horizontal orientation moves forward and rearward. In addition to the pass 34 described above, the first center robot C1 can access the vacuum chamber 45 and the resist chambers 41, 42, 43, and 44 provided in the first row CL1, a heat processing chamber 55 and a cooling unit 58 described later provided in the third row CL3, and a pass 57 provided at a boundary between the coater block 5 and the developer block 7 illustrated in FIG. 1. The resist chambers 41, 42, 43, and 44 correspond to a chamber of the present invention.

The first center robot C1 is movable forward and backward in the X direction and movable upward and downward in the Z direction so as to be able to convey the substrate W to each accessible position. Then, the first center robot C1 can direct a hand 56 holding the substrate W to any of the front, rear, left, and right.

In the third row CL3, the heat processing chamber 55 that heats the substrate W and the cooling unit 58 that cools the substrate W are arranged in the X direction. In the heat processing chamber 55, a circular hot plate 55a that heats the substrate W and a circular post-heating processing plate 55b that performs post-heating processing for lowering a temperature of the high-temperature substrate W are arranged in the Y direction. Whereas, the cooling unit 58 is provided with a circular cooling processing plate 58a that cools the substrate W at room temperature. In the third row CL3, in addition to being arranged in the X direction, the heat processing chambers 55 or the cooling units 58 are also stacked in the Z direction to form a multilayer body of chambers. The number of layers included in the multilayer body can be appropriately changed.

### <4. Developer Block>

The developer block 7 is configured to mainly develop the substrate W after the exposure processing. The developer block 7 includes a fifth row CL5 located on the rear side of the pass 57, a fourth row CL4 provided on the left side of the fifth row CL5, and the sixth row CL6 provided on the right side of the fifth row CL5. Therefore, the fifth row CL5 is located at a position sandwiched between the fourth row CL4 and the sixth row CL6 from left and right.

In the fourth row CL4, development chambers 77 are arranged in the X direction. The development chamber 77 has the spin chuck 8 that rotatably supports the substrate W, and the nozzle 10 that discharges chemical liquid. The fourth row CL4 of FIG. 1 shows a state in which two development chambers 77 are arranged in the front-rear direction. In the fourth row CL4, the development chambers 77 are stacked. The number of layers included in a multilayer body including the development chambers 77 can be appropriately changed.

The fifth row CL5 is a passage through which a second center robot C2 that conveys the substrate W in the horizontal orientation moves forward and rearward. In addition to the pass 57 described above, the second center robot C2 can also access the development chamber 77 included in the fourth row CL4, and a heat processing chamber 75, a cooling unit 78, and a pass 79 described later provided in the sixth row CL6.

Similarly to the first center robot C1, the second center robot C2 is movable forward and backward in the X direction and movable upward and downward in the Z direction so as to be able to convey the substrate W to each accessible position. Then, the second center robot C2 can direct a hand 76 holding the substrate W to at least any of the front, left, and right.

In the sixth row CL6, the heat processing chamber 75 that heats the substrate W and the cooling unit 78 that cools the substrate W are arranged in the X direction. The heat processing chamber 75 has a configuration similar to that of the heat processing chamber 55 in the third row. Therefore, the heat processing chamber 75 is configured by arranging a circular hot plate 75a and a circular post-heating processing plate 75b in the Y direction. The cooling unit 78 has a configuration similar to that of the cooling unit 58 of the third row CL3. Therefore, the cooling unit 78 is provided with a circular cooling processing plate 78a.

The pass 79 is provided at a rear end portion of the sixth row CL6. The substrate W in the horizontal orientation can move back and forth between the developer block 7 and the interface block 9 via the pass 79.

### <5. Interface Block>

The interface block 9 includes a pass 95 capable of cooling the placed substrate W, a first robot R1 capable of accessing the pass 95 and the above-described pass 79, and a second robot R2 capable of accessing the pass 95 and the exposure machine 2. The first robot R1 includes a hand 961 capable of gripping the substrate W in the horizontal orientation placed on the pass 79, and the second robot R2 includes a hand 962 capable of gripping the substrate W in the horizontal orientation placed on the pass 95.

The passes 95 are stacked in the Z direction to form a multilayer body.

### <6. Exposure Machine>

The exposure machine 2 receives the substrate W before the exposure processing conveyed by the second robot R2, performs the exposure processing, and burns a circuit pattern of a device on the photoresist layer of the substrate W. The substrate W after the exposure processing is passed to the second robot R2. Specific configuration examples of the exposure machine 2 include a stepper and a scanner.

### <7. Control Unit>

As illustrated in FIG. 1, the substrate processing apparatus 1 includes a control unit 139 related to control of the apparatus. Although not illustrated in FIG. 1, the control unit 139 is provided with a corresponding storage unit. The control unit 139 includes, for example, a central processing unit (CPU). A specific configuration of the control unit is not limited, and for example, different types of control related to the substrate processing apparatus 1 may be configured by a single processor, or different types of control may be configured by individual processors.

Examples of the control related to the control unit 139 include control related to the indexer robot IR, the first center robot C1, the second center robot C2, the first robot R1, and the second robot R2.

That is, the control unit 139 of the present example is configured to control a pump 15 and a pump 25, and controls the pump 15 on the basis of an output of a sensor 14. Specifically, when it can be determined by the sensor 14 that degassing has ended, the control unit 139 stops the pump 15 and ends a degassing mode to be described later.

The control unit 139 controls an output of the pump 15 so that a pressure sensor 51 has a predetermined value.

The control unit 139 of the present example has a function of switching the device used for the degassing processing between the first degassing device 6a and the second degassing device 6b. A state in which the control unit 139 of the present example exerts the function as the switching control unit will be described later.

The storage unit stores a program, parameters, and the like related to control. The storage unit may be configured by a single device or may be configured by individual devices corresponding to different types of control. In addition, the substrate processing apparatus 1 of the present example is not particularly limited to the configuration of the device that implements the storage unit.

### <8. Degassing Chamber>

FIG. 2 illustrates a configuration of the degassing chamber 6 and a state in which the degassing chamber 6 is connected to various pipes included in the resist chambers 41, 42, 43, and 44. As illustrated in FIG. 2, the degassing chamber 6 is provided with a plurality of degassing devices. The degassing chamber 6 of the present example includes the first degassing device 6a and the second degassing device 6b. In the present example, the first degassing device 6a and the second degassing device 6b are configured to degas a solvent alternately to avoid interruption of supply of the degassed liquid.

As the solvent, it is possible to use a solvent of photoresist liquid used for substrate processing by the resist chambers 41, 42, 43, and 44 at the time of forming a resist film. Specific examples of the solvent include organic solvents such as thinner, propylene glycol monomethyl ether (PGME), propylene glycol monomethyl ether (PGMEA), ethyl lactate, cyclohexane, 4-Methyl-2 pentanol (MIBC), and isopropyl alcohol (IPA).

A specific configuration of the first degassing device 6a will be described with reference to FIG. 2. As illustrated in FIG. 2, the first degassing device 6a includes a first tank 11 that stores the solvent, a three-way valve 12 that can inject the solvent into the first tank 11, a foaming device 13 that foams the solvent flowing out of the first tank 11, the sensor 14 that is provided on the downstream side of the foaming device 13 and detects a foaming state of the solvent, the pump 15 provided on the downstream side of the sensor 14, and a valve 16 provided on the downstream side of the pump 15. The first tank 11 corresponds to a tank of the present invention, and is configured to store liquid to be degassed. The foaming device 13 is configured to generate bubbles from the liquid, and the pump 15 is configured to cause the liquid to flow to the foaming device 13.

The first tank 11 is provided with three through holes. That is, an inflow port 105 and an outflow port 106 are provided in a bottom surface of the first tank 11, and an exhaust port 107 is provided in a lid body of the first tank 11.

### <9. First Degassing Device: Pipe and Three-way Valve>

Pipes and the three-way valve 12 related to the first degassing device 6a will be described. The inflow port 105 of the first tank 11 is located downstream of the three-way valve 12, and the inflow port 105 and the three-way valve 12 are connected to each other via an inflow pipe 19a.

The three-way valve 12 is connected to a solvent supply source 50 through an upstream pipe 20c. The three-way valve 12 is connected to the pump 15 through a return pipe 19c. Therefore, the three-way valve 12 can allow communication between the solvent supply source 50 and the inflow port 105, and can also allow communication between the pump 15 and the inflow port 105. The three-way valve 12 can alternatively select whether the solvent supply source 50 communicates with the inflow port 105 or the pump 15 communicates with the inflow port 105. For example, since the three-way valve 12 in FIG. 2 is in a state in which a flow path from the solvent supply source 50 to the inflow port 105 is closed, the solvent does not flow from the solvent supply source 50 to the inflow port 105. A state in which the solvent flows from the solvent supply source 50 to the inflow port 105 will be described later. In addition, the three-way valve 12 may be in a closed state in which neither the solvent supply source 50 nor the pump 15 communicates with the inflow port 105. The three-way valve 12 in the closed state will also be described later.

The return pipe 19c is configured to allow communication between the first tank 11 and the foaming device 13, to cause liquid to circulate between the first tank 11 and the foaming device 13.

The outflow port 106 of the first tank 11 is located upstream of the foaming device 13, and the outflow port 106, the foaming device 13, the sensor 14, the pump 15, and the valve 16 are disposed in this order from upstream to downstream, and are connected in series to each other via an outflow pipe 19b. Therefore, the solvent flowing out from the outflow port 106 of the first tank 11 passes through the foaming device 13, the sensor 14, and the pump 15 to reach the valve 16.

The return pipe 19c is a pipe branching from the outflow pipe 19b between the pump 15 and the valve 16. The return pipe 19c communicates from a branch point 19d on the outflow pipe 19b to the three-way valve 12.

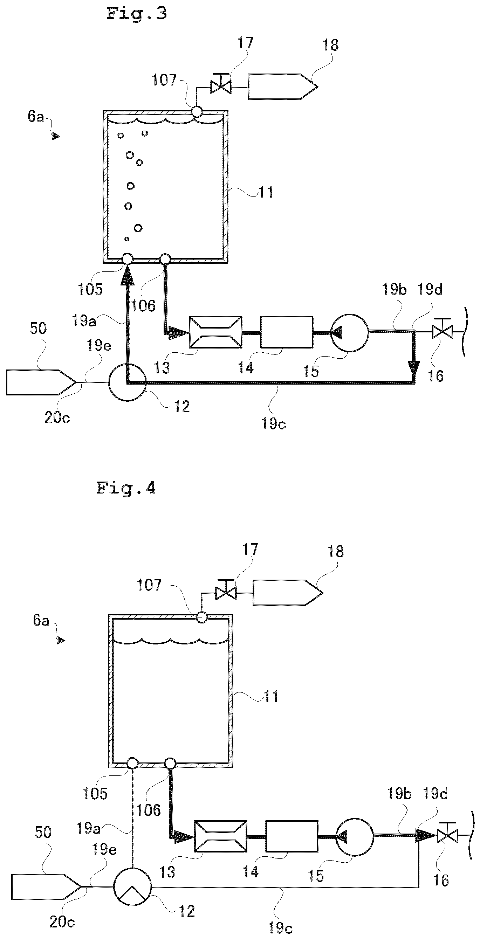

As illustrated in FIG. 3, when the three-way valve 12 of the present example is switched to the return pipe 19c side and the valve 16 is brought into a closed state, the first degassing device 6a enters the degassing mode. The degassing mode is a mode in which gas dissolved in the solvent stored in the first tank 11 is foamed by the foaming device 13 and removed from the solvent, and is a mode in which the solvent is circulated between the first tank 11 and the foaming device 13 via the return pipe 19c.

As illustrated in FIG. 4, when the three-way valve 12 of the present example is in the closed state and the valve 16 is in an opened state, the first degassing device 6a enters a liquid supply mode. The liquid supply mode is a mode in which the solvent stored in the first tank 11 is supplied to the resist chambers 41, 42, 43, and 44. The closed state of the three-way valve 12 is a state in which the three-way valve 12 does not allow flowing of the solvent.

The first tank 11 includes the exhaust port 107. The exhaust port 107 is connected to a drain 18 through a valve 17. The exhaust port 107 is provided to discharge gas stored in an upper portion of the first tank 11 from the first tank 11. In the following description of the present example, the valve 17 is appropriately brought into an opened state to release gas from the first tank 11.

### <10. First Degassing Device: Foaming Device>

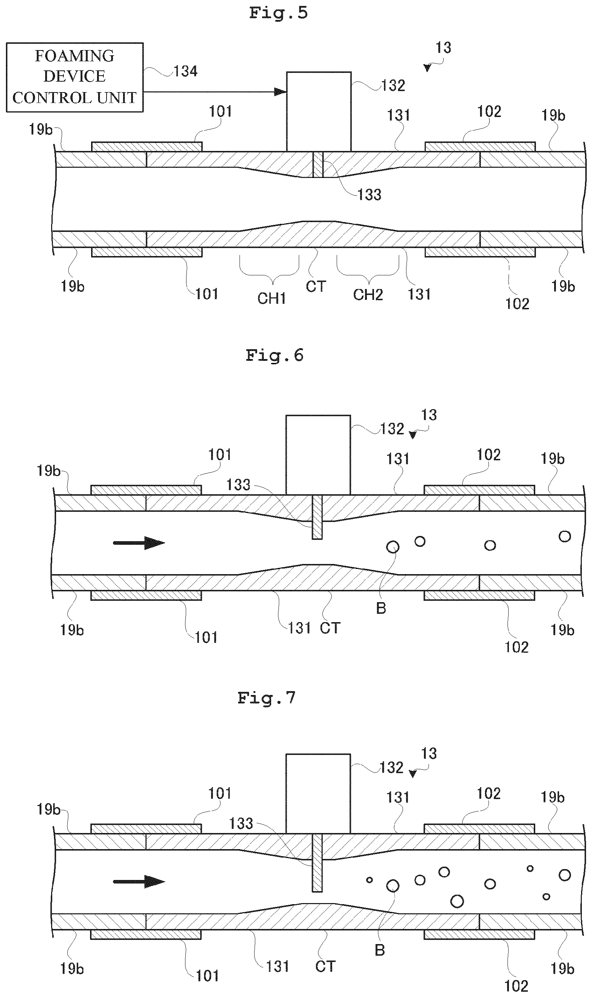

FIG. 5 illustrates a configuration of the foaming device 13 of the present example. The foaming device 13 of the present example has a tubular shape and is provided between the upstream outflow pipe 19b and the downstream outflow pipe 19b. That is, the foaming device 13 is provided with a cylindrical base 131. An introduction port for introducing the solvent and a release port for releasing the solvent are set in the base 131. The introduction port of the base 131 is connected to the upstream outflow pipe 19b via a joint 101. The release port of the base 131 is connected to the downstream outflow pipe 19b via a joint 102.

An inner diameter of the base 131 varies depending on a portion of the base 131. That is, the base 131 has a large inner diameter for the introduction port and the release port, and has a small inner diameter for a central portion CT sandwiched between the introduction port and the release port. A first transition portion CH1 whose inner diameter gradually decreases is provided between the introduction port and the central portion CT. A second transition portion CH2 whose inner diameter gradually increases is provided between the central portion CT and the release port.

The central portion CT is a passage having a liquid flow path narrower than that of the second transition portion CH2, and is configured to introduce liquid into the second transition portion CH2. The first transition portion CH1 is configured to introduce liquid to be degassed into the central portion CT.

A needle 133 is provided in the central portion CT of the base 131 and can enter and leave an internal space of the base 131. A change in degree of extension of the needle 133 allows adjustment of resistance to the flow of the solvent in the base 131.

For example, when the needle 133 is fully retracted from the internal space of the base 131, the foaming device 13 is brought into a fully opened state. Then, for example, when the needle 133 fully protrudes into the internal space of the base 131, the foaming device 13 is brought into a fully closed state.

A motor 132 is configured to drive the needle 133. A foaming device control unit 134 controls the motor 132 to cause the opening and closing operation of the foaming device 13.

The needle 133 is configured to adjust a cross-sectional area of a flow path formed by the central portion CT.

When the foaming device 13 is in the fully opened state, the resistance to the flow of the solvent passing through the base 131 is minimized, and the solvent easily flows to the base 131. When the foaming device 13 is in the fully closed state, the resistance to the flow of the solvent passing through the base 131 is maximized, and the solvent flows less easily to the base 131 or stops flowing. When the foaming device 13 is in the fully closed state, the passage of the solvent may be allowed or not allowed.

FIG. 6 illustrates a state where the solvent is foamed when the foaming device 13 is close to the fully opened state. When the solvent passes through the foaming device 13 in this state, the pressure applied to the solvent in the central portion CT of the base 131 increases. This pressure returns to the original pressure when the solvent is away from the central portion CT. By causing such a change in pressure, the gas dissolved in the solvent can no longer be dissolved in the solvent and becomes bubbles B. In this manner, the foaming device 13 foams the solvent.

FIG. 7 illustrates a state where the solvent is foamed when the foaming device 13 is close to the fully closed state. When the solvent passes through the foaming device 13 in this state, the pressure applied to the solvent in the central portion CT of the base 131 becomes higher than that in the case of FIG. 6. This pressure rapidly decreases when the solvent is away from the central portion CT. By causing such a change in pressure, the gas dissolved in the solvent can no longer be dissolved in the solvent, and generates many bubbles B. In this manner, an amount of bubbles generated in the solvent can be adjusted by opening and closing the foaming device 13.

### <11. First Degassing Device: Sensor>

The sensor 14 is located downstream of the foaming device 13, and measures an amount of bubbles contained in the flowing solvent. The sensor 14 includes a light emitter that emits laser light and a light receiver that detects laser light. The light emitter and the light receiver are installed so as to sandwich the solvent passage. When there are many bubbles contained in the flowing solvent, the laser light is disturbed by the bubbles B accordingly. Such disturbance does not occur when the flowing solvent does not contain bubbles. In this manner, the sensor 14 can measure the amount of bubbles contained in the solvent flowing on the basis of an output of the light receiver. The sensor 14 is not limited to an optical sensor, and can be configured by, for example, an ultrasonic sensor. As described above, the sensor 14 is configured to detect a degassing situation of liquid during the degassing processing.

### <12. First Degassing Device: Pump>

The pump 15 is located downstream of the sensor 14, and is configured to create a flow of the solvent. When the pump 15 operates, the solvent stored in the first tank 11 passes through the outflow port 106, the foaming device 13, and the sensor 14, and reaches the branch point 19d. In this manner, the pump 15 is provided in the outflow pipe 19b, and feeds processing liquid.

A specific example of the pump 15 is a liquid sending pump. The liquid sending pump is a pump that can keep a pressure of liquid constant while adjusting a rotational speed of a motor when a set value of the pressure is given by a control unit. By using such a liquid sending pump, even in a configuration having a plurality of nozzles 10 on the downstream side, a discharge amount of liquid in each nozzle 10 can be made constant. The pump 15 of the present example is not limited to the liquid sending pump described above, and other pumps can also be used.

### <13. Second Degassing Device>

As illustrated in FIG. 2, the degassing chamber 6 of the present example includes two degassing devices. That is, the degassing chamber 6 includes the first degassing device 6a described above, and the second degassing device 6b having the same configuration as the first degassing device 6a. Similarly to the first degassing device 6a, the second degassing device 6b can be operated in the degassing mode and the liquid supply mode.

That is, similarly to the first degassing device 6a, the second degassing device 6b includes a second tank 21, a three-way valve 22, a foaming device 23, a sensor 24, the pump 25, and a valve 26. Similarly to the first degassing device 6a described above, the second tank 21 is provided with three through holes of an inflow port 205, an outflow port 206, and an exhaust port 207. Similarly to the first degassing device 6a, the second degassing device 6b also has a configuration in which an inflow pipe 29a allows communication between the inflow port 205 and the three-way valve 22, and a configuration in which the three-way valve 22 allows communication between the solvent supply source 50 and the inflow port 205, and communication between the pump 25 and the inflow port 205 through a return pipe 29c. In addition, similarly to the first degassing device 6a, the foaming device 23, the sensor 24, the pump 25, and the valve 26 are arranged in series through an outflow pipe 29b, and the return pipe 29c allows communication between a branch point 29d and the three-way valve 22. Similarly to the first degassing device 6a, the second tank 21 includes the exhaust port 207. The exhaust port 207 is connected to a drain 28 through a valve 27.

The degassing chamber 6 of the present example has a configuration in which the first degassing device 6a and the second degassing device 6b are arranged in parallel. That is, the upstream pipe 20c connected to the solvent supply source 50 is branched at a branch point 19e into a diverging pipe toward the first degassing device 6a and a diverging pipe toward the second degassing device 6b. The outflow pipe 19b extending from the first degassing device 6a and the outflow pipe 29b extending from the second degassing device 6b are connected to a merging pipe 20b at a merging point 20a. That is, the solvent in the solvent supply source 50 is degassed by either the first degassing device 6a or the second degassing device 6b, and reaches the merging pipe 20b. The outflow pipe 19b and the merging pipe 20b are configured to allow the solvent to flow from the first tank 11, and correspond to a main pipe of the present invention.

### <14. Liquid Supply to Resist Chamber>

Next, with reference to FIG. 2, pipes used when the degassed solvent flowing through the merging pipe 20b is supplied to the resist chambers 41, 42, 43, and 44 will be described. These pipes are pipes included in the coater block 5. That is, the solvent having reached the merging pipe 20b is distributed to the four resist chambers 41, 42, 43, and 44 through various pipes.

The merging pipe 20b communicates with a regulator 52, a regulator 53, a regulator 54, and the pressure sensor 51. A valve 61 and the like are provided at some midpoint of the pipes, and can control whether or not to allow the solvent to pass downstream. The regulator 52 and the like are provided at some midpoint of the pipes, and can control a pressure of a solvent downstream. The regulator 52 and the like can set the pressure of the solvent downstream within a range from zero to a predetermined pressure. The predetermined pressure is an upstream pressure in the regulator 52 and the like. That is, the regulator 52 and the like is not able to set the pressure of the solvent on a secondary side to a pressure higher than the pressure of the solvent on a primary side.

The merging pipe 20b has a first branch point TP1, a second branch point TP2, and a third branch point TP3, and various diverging pipes are branched therefrom. At the first branch point TP1, a pot-rinse pipe PTR from the merging pipe 20b toward the regulator 52 is branched. The regulator 52 is provided at some midpoint of the pot-rinse pipe PTR. The merging pipe 20b is provided with the second branch point TP2 downstream of the first branch point TP1. At the second branch point TP2, a back-rinse pipe BR and a cup-rinse pipe CR extending from the merging pipe 20b toward the regulator 53 are branched. The regulator 53 is provided at some midpoint of the back-rinse pipe BR and the cup-rinse pipe CR. Similarly, in the merging pipe 20b, the third branch point TP3 is provided downstream of the second branch point TP2. At the third branch point TP3, an edge-rinse pipe EBR extending from the merging pipe 20b toward the regulator 54 is branched. The regulator 54 is provided at some midpoint of the edge-rinse pipe EBR.

The pot-rinse pipe PTR, the back-rinse pipe BR, the cup-rinse pipe CR, and the edge-rinse pipe EBR correspond to a second diverging pipe of the present invention.

At the third branch point TP3, a pre-wet pipe PW is branched from the merging pipe 20b. The pre-wet pipe PW corresponds to a first diverging pipe of the present invention. As described above, the substrate processing apparatus 1 of the present example includes a plurality of diverging pipes formed by branching the merging pipe 20b downstream of the pump 15 and configured to deliver the solvent to a plurality of types of processing units in the resist chamber 41. Specifically, the diverging pipe is the first diverging pipe or the second diverging pipe. That is, the diverging pipe of the present example includes the pre-wet pipe PW having the largest flow rate of the solvent, the pot-rinse pipe PTR having a flow rate of the solvent smaller than the flow rate of the pre-wet pipe PW, and the like.

The pre-wet pipe PW as the first diverging pipe is connected to the nozzle 10 that discharges the solvent to the upper surface of the substrate W in the resist chambers 41, 42, 43, and 44. The pre-wet pipe PW as the first diverging pipe is located downstream of the pot-rinse pipe PTR, the back-rinse pipe BR, the cup-rinse pipe CR, and the edge-rinse pipe EBR which are the second diverging pipes described above.

The pot-rinse pipe PTR as the second diverging pipe is branched into four pot-rinse branch pipes PTR1, PTR2, PTR3, and PTR4. These are distributed to the respective resist chambers 41, 42, 43, and 44. Similarly, the back-rinse pipe BR as the second diverging pipe is branched into four back-rinse branch pipes BR1, BR2, BR3, and BR4. These are distributed to the respective resist chambers 41, 42, 43, and 44. Similarly, the cup-rinse pipe CR as the second diverging pipe is branched into four cup-rinse branch pipes CR1, CR2, CR3, and CR4. These are distributed to the respective resist chambers 41, 42, 43, and 44. Similarly, the edge-rinse pipe EBR as the second diverging pipe is distributed to four edge-rinse branch pipes EBR1, EBR2, EBR3, and EBR4. These are distributed to the respective resist chambers 41, 42, 43, and 44. Similarly, the pre-wet pipe PW as the first diverging pipe is distributed to four pre-wet branch pipes PW1, PW2, PW3, and PW4. These are distributed to the respective resist chambers 41, 42, 43, and 44.

The pressure sensor 51 is a pressure gauge provided between the third branch point TP3 and the valve 61, and is configured to measure a pressure applied to the solvent reaching the valve 61. In addition to the valve 61, a valve 62, a valve 63, and a valve 64 are connected in parallel downstream of the pressure sensor 51.

The resist chamber 41 includes a plurality of solvent discharge ports including nozzles and the like. The coater block 5 is provided with a valve that controls whether to discharge liquid to various discharge ports.

The coater block 5 includes the pot-rinse branch pipe PTR1, the back-rinse branch pipe BR1, the cup-rinse branch pipe CR1, the edge-rinse branch pipe EBR1, and the pre-wet branch pipe PW1 as pipes for supplying the solvent to the resist chamber 41.

The pot-rinse branch pipe PTR1 is a pipe intended to supply the solvent to a standby pod for cleaning the nozzle 10. The pot rinse is a process of cleaning a standby pod in which a resist nozzle stands by. A tip end of the nozzle 10 that discharges photoresist liquid can be cleaned by the solvent supplied to the standby pod. Further, by filling the inside of the standby pod with vapor of the solvent, drying of the tip end of the nozzle 10 can be mitigated. A flow rate of the solvent to the resist chamber 41 at the time of the pot rinsing is, for example, 95 ml/min to 130 ml/min.

The back-rinse branch pipe BR1 is a pipe intended to supply the solvent to the resist chamber 41 at the time of back rinsing for cleaning the back surface of the substrate W. The cup-rinse branch pipe CR1 is a pipe intended to supply the solvent to the resist chamber 41 when cleaning a cup that suppresses scattering of the photoresist liquid to the outside of the spin chuck 8. A flow rate of the solvent to the resist chamber 41 at the time of back rinsing is, for example, 100 ml/min to 130 ml/min.

The edge-rinse branch pipe EBR1 is a pipe intended to supply the solvent to the resist chamber 41 when removing the photoresist liquid in a peripheral edge portion of the substrate W coated with the photoresist. A flow rate of the solvent to the resist chamber 41 at the time of edge rinsing is, for example, 15ml/min to 30ml/min.

The pre-wet branch pipe PW1 is a pipe intended to supply the solvent to the resist chamber 41 at the time of pre-wetting that is performed prior to supplying the photoresist liquid to the substrate W. A flow rate of the solvent to the resist chamber 41 at the time of pre-wetting is, for example, 75ml/min to 150ml/min.

The pot-rinse branch pipe PTR1 is connected to the regulator 52. Similarly, the back-rinse branch pipe BR1 and the cup-rinse branch pipe CR1 are connected to the regulator 53. The edge-rinse branch pipe EBR1 is connected to the regulator 54.

The pre-wet branch pipe PW1 is directly connected to the pressure sensor 51 without passing through a regulator. The pre-wet processing requires a relatively large amount of solvent, and a pressure applied to the pre-wet branch pipe PW1 is preferably high. In the present example, in response to such a request, a regulator for reducing the pressure of the solvent is not provided upstream of the pre-wet branch pipe PW1.

A valve 91 is located at some midpoint of the pot-rinse branch pipe PTR1, and is configured to control whether or not to allow the solvent to flow through the pot-rinse branch pipe PTR1. A valve 81 is located at some midpoint of the back-rinse branch pipe BR1 and the cup-rinse branch pipe CR1, and is configured to control whether or not to allow the solvent to flow through the back-rinse branch pipe BR1 and the cup-rinse branch pipe CR1. A valve 71 is located at some midpoint of the edge-rinse branch pipe EBR1, and is configured to control whether or not to allow the solvent to flow through the edge-rinse branch pipe EBR1. The valve 61 is located at some midpoint of the pre-wet branch pipe PW1, and is configured to control whether or not to allow the solvent to flow through the pre-wet branch pipe PW1.

The coater block 5 has a plurality of resist chambers similar to the resist chamber 41. Pipes for supplying the solvent to these resist chambers have a configuration similar to that of the resist chamber 41.

That is, the coater block 5 includes the pot-rinse branch pipe PTR2, the back-rinse branch pipe BR2, the cup-rinse branch pipe CR2, the edge-rinse branch pipe EBR2, and the pre-wet branch pipe PW2 as pipes for supplying the solvent to the resist chamber 42.

The pot-rinse branch pipe PTR2 is connected to the regulator 52. Similarly, the back-rinse branch pipe BR2 and the cup-rinse branch pipe CR2 are connected to the regulator 53. The edge-rinse branch pipe EBR2 is connected to the regulator 54. The pre-wet branch pipe PW2 is directly connected to the pressure sensor 51 without passing through a regulator.

A valve 92 is located at some midpoint of the pot-rinse branch pipe PTR2, and is configured to control whether or not to allow the solvent to flow through the pot-rinse branch pipe PTR2. A valve 82 is located at some midpoint of the back-rinse branch pipe BR2 and the cup-rinse branch pipe CR2, and is configured to control whether or not to allow the solvent to flow through the back-rinse branch pipe BR2 and the cup-rinse branch pipe CR2. A valve 72 is located at some midpoint of the edge-rinse branch pipe EBR2, and is configured to control whether or not to allow the solvent to flow through the edge-rinse branch pipe EBR2. The valve 62 is located at some midpoint of the pre-wet branch pipe PW2, and is configured to control whether or not to allow the solvent to flow through the pre-wet branch pipe PW2.

In addition, the coater block 5 includes the pot-rinse branch pipe PTR3, the back-rinse branch pipe BR3, the cup-rinse branch pipe CR3, the edge-rinse branch pipe EBR3, and the pre-wet branch pipe PW3 as pipes for supplying the solvent to the resist chamber 43.

The pot-rinse branch pipe PTR3 is connected to the regulator 52. Similarly, the back-rinse branch pipe BR3 and the cup-rinse branch pipe CR3 are connected to the regulator 53. The edge-rinse branch pipe EBR3 is connected to the regulator 54. The pre-wet branch pipe PW3 is directly connected to the pressure sensor 51 without passing through a regulator.

A valve 93 is located at some midpoint of the pot-rinse branch pipe PTR3, and is configured to control whether or not to allow the solvent to flow through the pot-rinse branch pipe PTR3. A valve 83 is located at some midpoint of the back-rinse branch pipe BR3 and the cup-rinse branch pipe CR3, and is configured to control whether or not to allow the solvent to flow through the back-rinse branch pipe BR3 and the cup-rinse branch pipe CR3. A valve 73 is located at some midpoint of the edge-rinse branch pipe EBR3, and is configured to control whether or not to allow the solvent to flow through the edge-rinse branch pipe EBR3. The valve 63 is located at some midpoint of the pre-wet branch pipe PW3, and is configured to control whether or not to allow the solvent to flow through the pre-wet branch pipe PW3.

Similarly, the coater block 5 includes the pot-rinse branch pipe PTR4, the back-rinse branch pipe BR4, the cup-rinse branch pipe CR4, the edge-rinse branch pipe EBR4, and the pre-wet branch pipe PW4 as pipes for supplying the solvent to the resist chamber 44.

The pot-rinse branch pipe PTR4 is connected to the regulator 52. Similarly, the back-rinse branch pipe BR4 and the cup-rinse branch pipe CR4 are connected to the regulator 53. The edge-rinse branch pipe EBR4 is connected to the regulator 54. The pre-wet branch pipe PW4 is directly connected to the pressure sensor 51 without passing through a regulator.

A valve 94 is located at some midpoint of the pot-rinse branch pipe PTR4, and is configured to control whether or not to allow the solvent to flow through the pot-rinse branch pipe PTR4. A valve 84 is located at some midpoint of the back-rinse branch pipe BR4 and the cup-rinse branch pipe CR4, and is configured to control whether or not to allow the solvent to flow through the back-rinse branch pipe BR4 and the cup-rinse branch pipe CR4. A valve 74 is located at some midpoint of the edge-rinse branch pipe EBR4, and is configured to control whether or not to allow the solvent to flow through the edge-rinse branch pipe EBR4. The valve 64 is located at some midpoint of the pre-wet branch pipe PW4, and is configured to control whether or not to allow the solvent to flow through the pre-wet branch pipe PW4.

### <15. Operation of Degassing Device>

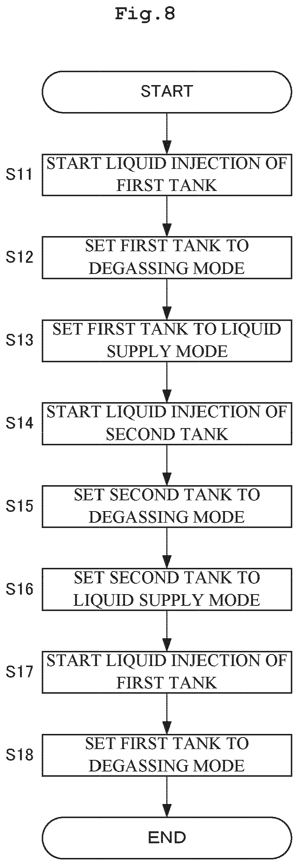

Hereinafter, an operation of the degassing device according to the present example will be described with reference to a flowchart according to FIG. 8.

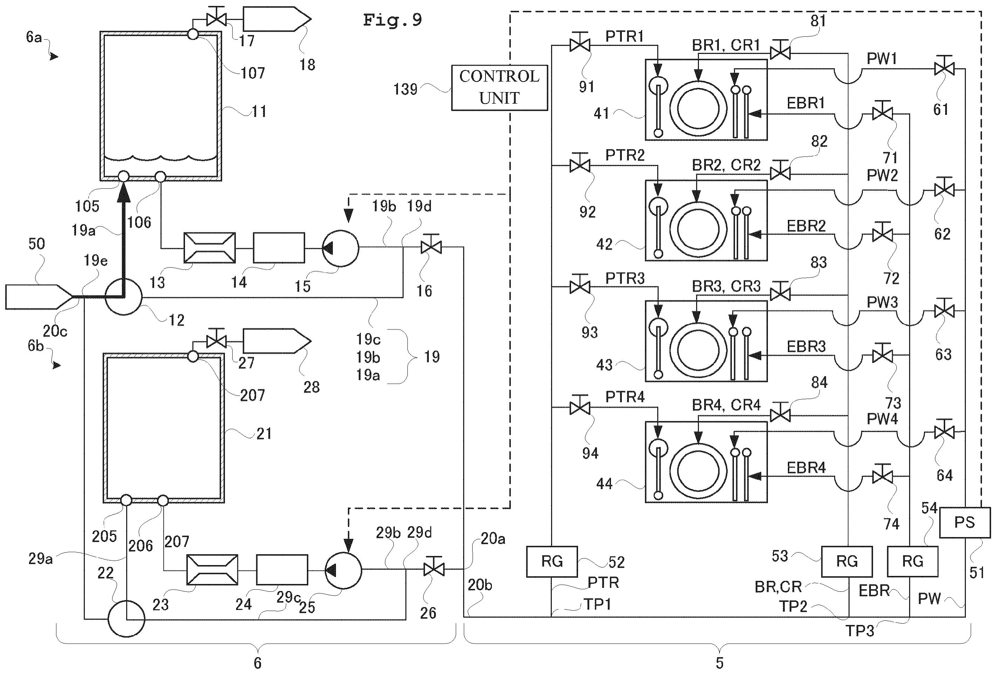

Step S11: Liquid injection of the solvent from the solvent supply source 50 into the first tank 11 in the first degassing device 6a is started. FIG. 9 illustrates a solvent flow in this step. Since the three-way valve 12 in this step has been switched to the solvent supply source 50 side, the solvent of the solvent supply source 50 reaches the first tank 11 through the upstream pipe 20c, the three-way valve 12, the inflow pipe 19a, and the inflow port 105. At this time, since the pump 15 is not operated and the valve 16 is in a closed state, the solvent in this step does not flow through the outflow pipe 19b and the return pipe 19c. That is, the solvent of the solvent supply source 50 is stored in the first tank 11.

Since the three-way valve 22 of the second degassing device 6b in this step has been switched to the return pipe 29c side, the solvent does not flow from the solvent supply source 50 toward the second tank 21.

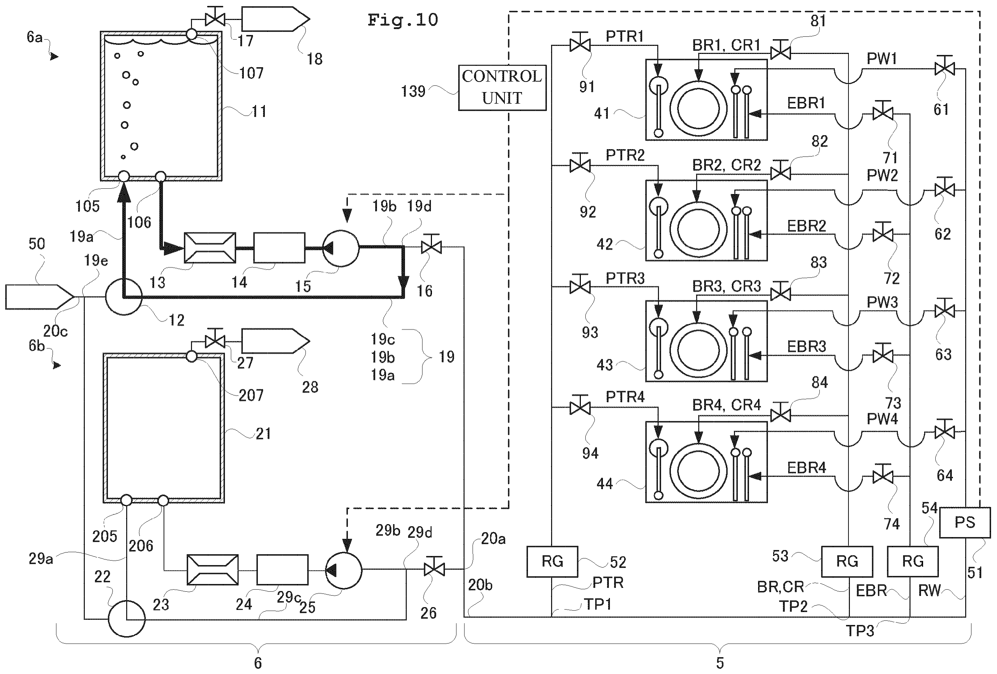

Step S12: When the storage of the solvent into the first tank 11 has ended, the first degassing device 6a enters the degassing mode. In the degassing mode, first, the three-way valve 12 is switched to the return pipe 19c side. The pump 15 then operates. FIG. 10 illustrates a solvent flow in this step. The solvent in the first tank 11 in this step passes through the outflow port 106, the foaming device 13, the sensor 14, and the pump 15, passes through the return pipe 19c from the branch point 19d to reach the three-way valve 12, and further reaches the inflow port 105 of the first tank 11 through the inflow pipe 19a from the three-way valve 12. At this time, the valve 16 is in a closed state.

Bubbles generated in the foaming device 13 and mixed in the solvent pass through the return pipe 19c and return to the first tank 11. Since the bubbles are lighter than the solvent, the bubbles are accumulated at the upper portion of the first tank 11 to form a gas phase.

The solvent stored in the first tank 11 is continuously degassed many times following the path as illustrated in FIG. 10. That is, the first degassing device 6a of the present example can appropriately adjust a degree of degassing processing by increasing or decreasing the number of times of degassing the solvent. Such adjustment can also be performed in the second degassing device 6b having a configuration similar to that of the first degassing device 6a. A detection result of the sensor 14 can be used to determine whether degassing has been sufficiently completed.

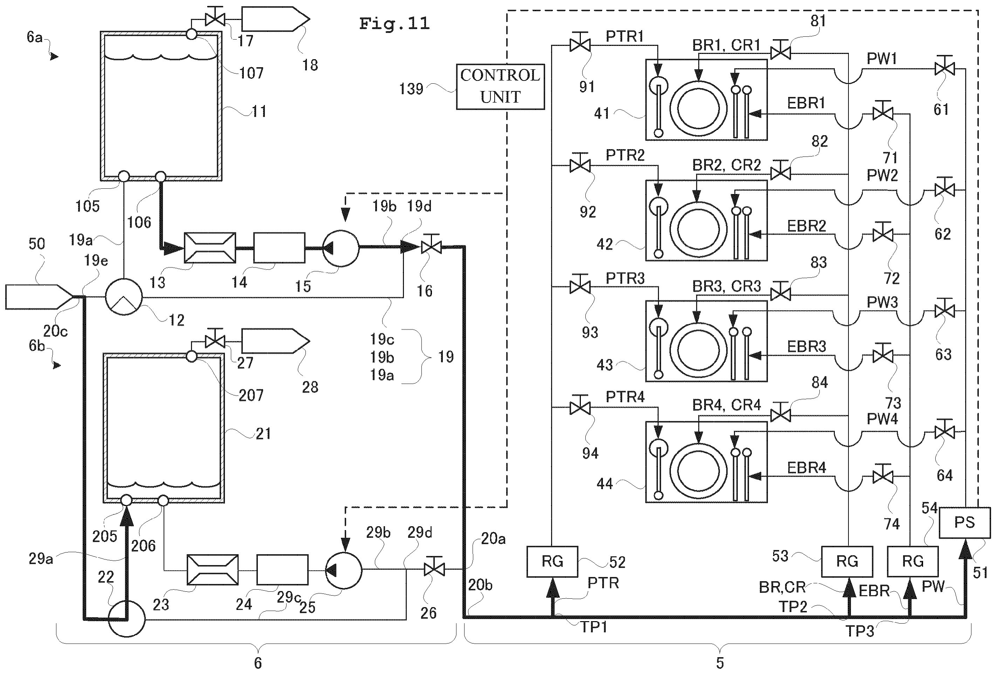

Step S13: FIG. 11 illustrates a solvent flow in this step. When the degassing of the solvent stored in the first tank 11 has ended, the first degassing device 6a enters the liquid supply mode. In the liquid supply mode, first, the three-way valve 12 is brought into the closed state. The three-way valve 12 in the closed state does not allow flowing of the solvent. Therefore, the solvent in this step does not flow into the first tank 11 from the inflow port 105. Then, the valve 16 is brought into an opened state. Then, the solvent stored in the first tank 11 passes through the foaming device 13, the sensor 14, the pump 15, and the branch point 19d to reach the valve 16, and further advances toward the first branch point TP1. In this regard, the foaming device 13 at this time is desirably in the fully opened state.

In this step, when any one of the valves 61, 62, 63, and 64, the valves 71, 72, 73, and 74, the valves 81, 82, 83, and 84, and the valves 91, 92, 93, and 94 in a closed state is brought into an opened state, the solvent having reached the pressure sensor 51 passes through the pipe corresponding to the valve in the opened state to reach the resist chamber.

Step S14: After the first degassing device 6a enters the liquid supply mode, supply of the solvent to the second tank 21 in the second degassing device 6b is started. This operation is a measure in view of the first tank 11 in the first degassing device 6a becoming empty. FIG. 11 also illustrates a solvent flow in this step. Since the three-way valve 22 in this step has been switched to the solvent supply source 50 side, the solvent of the solvent supply source 50 reaches the second tank 21 through the upstream pipe 20c, the three-way valve 22, the inflow pipe 29a, and the inflow port 205. At this time, since the pump 25 is not operated and the valve 26 is in a closed state, the solvent in this step does not flow through the outflow pipe 29b and the return pipe 29c. That is, the solvent of the solvent supply source 50 is stored in the second tank 21.

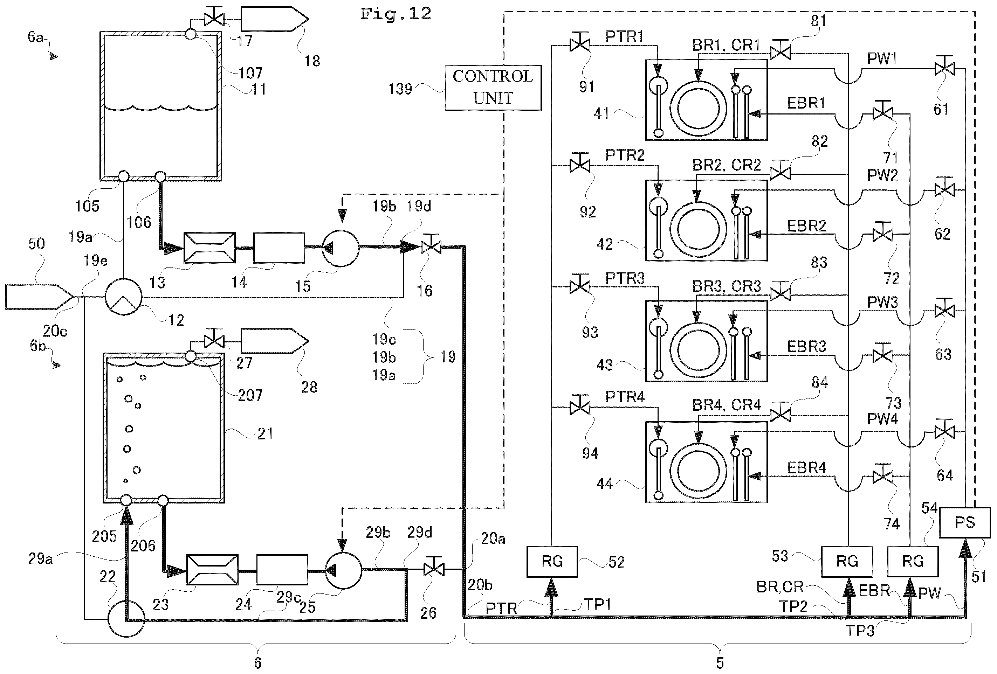

Step S15: When the storage of the solvent into the second tank 21 has ended, the second degassing device 6b enters the degassing mode. In the degassing mode, first, the three-way valve 22 is switched to the return pipe 29c side. The pump 25 then operates. FIG. 12 illustrates a solvent flow in this step. The solvent in the second tank 21 in this step passes through the outflow port 206, the foaming device 23, the sensor 24, and the pump 25, passes through the return pipe 29c from the branch point 29d to reach the three-way valve 22, and further reaches the inflow port 205 of the second tank 21 through the inflow pipe 29a from the three-way valve 22. At this time, the valve 26 is in a closed state. In this manner, the solvent is degassed by the second degassing device 6b.

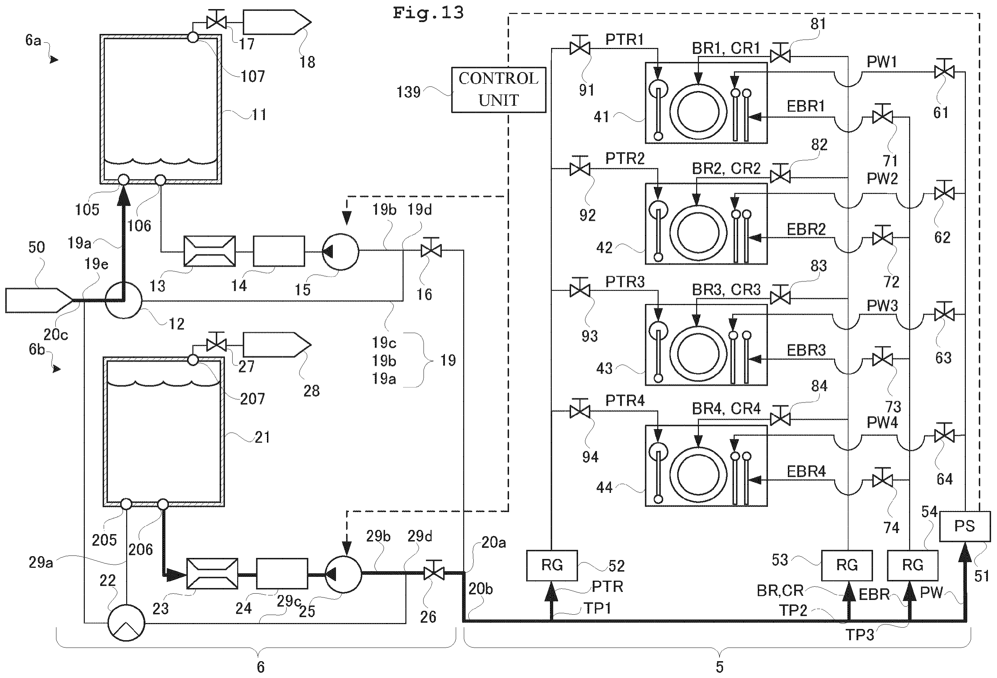

Step S16: When the first tank 11 of the first degassing device 6a in the liquid supply mode becomes empty, the second degassing device 6b enters the liquid supply mode. In the liquid supply mode, first, the three-way valve 22 is brought into the closed state. The three-way valve 22 in the closed state does not allow flowing of the solvent. Therefore, the solvent in this step does not flow into the second tank 21 from the inflow port 205. Then, the valve 26 is brought into an opened state. Then, the solvent stored in the second tank 21 passes through the foaming device 23, the sensor 24, the pump 25, and the branch point 29d to reach the valve 26, and further advances toward the first branch point TP1. In this regard, the foaming device 23 at this time is desirably in the fully opened state. FIG. 13 illustrates a solvent flow in this step.

Step S17: When the second degassing device 6b enters the liquid supply mode, next, liquid injection into the first tank 11 is started. FIG. 13 illustrates a solvent flow in this step.

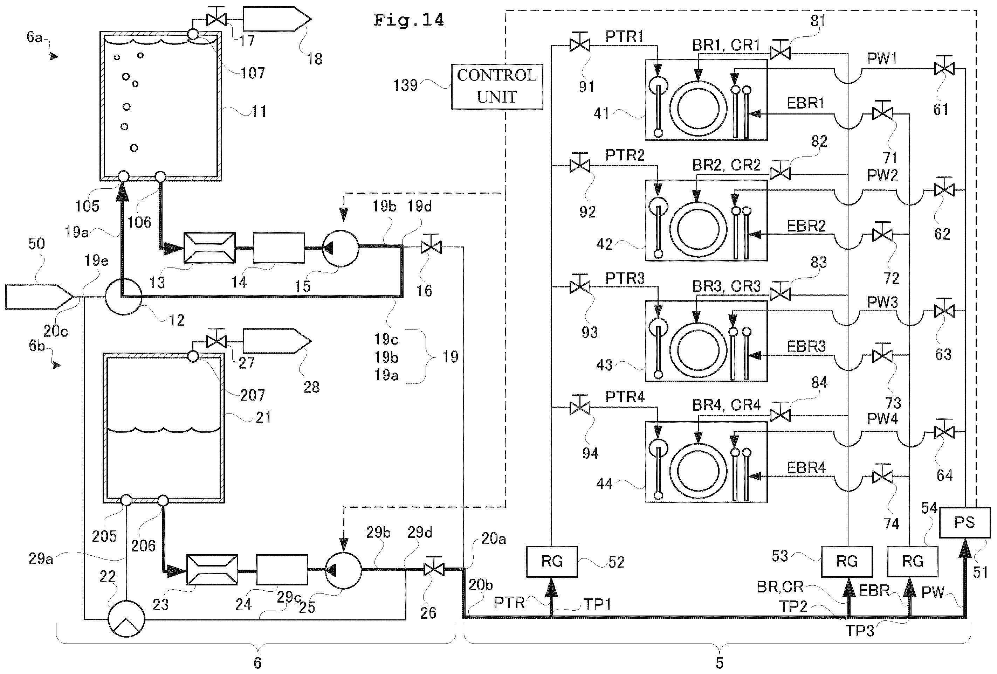

Step S18: When the liquid injection into the first tank 11 has ended, the first degassing device 6a enters the degassing mode. FIG. 14 illustrates a solvent flow in this step. When the degassing of the first tank 11 is completed, preparation for setting the first degassing device 6a to the liquid supply mode is completed. In this way, the operation of the degassing chamber 6 of the present example ends.

### <16. Switching Control Unit>

By setting the first degassing device 6a to the liquid supply mode and setting the second degassing device 6b to the degassing mode, the control unit 139 supplies the solvent to the resist chambers 41, 42, 43, and 44 through the first degassing device 6a, and performs degassing processing of the solvent through the second degassing device 6b. In addition, by setting the second degassing device 6b to the liquid supply mode and setting the first degassing device 6a to the degassing mode, the control unit 139 can also supply the solvent to the resist chambers 41, 42, 43, and 44 through the second degassing device 6b and perform the degassing processing of the solvent through the first degassing device 6a. If the control unit 139 performs the substrate processing while switching the liquid supply source between the first degassing device 6a and the second degassing device 6b, the supply of the solvent from the degassing chamber 6 is not interrupted.

### <17. Feedback Control by Pressure Sensor>

Next, feedback control by the pressure sensor 51 will be described with reference to FIG. 2. When the first degassing device 6a or the second degassing device 6b is in the liquid supply mode, the pressure sensor 51 measures a pressure applied to the solvent in the pre-wet branch pipes PW1, PW2, PW3, and PW4. When the pressure measured at this time is less than a reference pressure, the pre-wet processing of the substrate may not be sufficiently performed due to the insufficient pressure of the solvent. Therefore, on the basis of the detection result of the pressure sensor 51, the control unit 139 increases an output of the pump 15 or the pump 25 to cause the pressure applied to the solvent in the pre-wet branch pipes PW1, PW2, PW3, and PW4 to reach the reference pressure. Which pump is used for such feedback control is determined based on which degassing device is in the liquid supply mode.

As described above, if the feedback control of the solvent pressure is performed on the basis of the pressure applied to the solvent in the pre-wet branch pipes PW1, PW2, PW3, and PW4, various types of processing using the solvent can be reliably performed. In the pre-wet branch pipes PW1, PW2, PW3, and PW4, a larger amount of solvent flows than in other pipes such as the pot-rinse branch pipe PTR1. Therefore, the pressure applied to the solvent in the pre-wet branch pipes PW1, PW2, PW3, and PW4 is higher than the pressure applied to the solvent in the other pipes. Such a pressure difference is achieved by the regulators 52, 53, and 54. Therefore, if the pressure of a solvent liquid supply system is adjusted on the basis of the pre-wet branch pipes PW1, PW2, PW3, and PW4, the highest pressure among various pipes can be reliably achieved.

That is, according to the substrate processing system according to the present example, since the feedback control cancels pressure fluctuation generated in a configuration in which a usage amount of the solvent is increased and decreased by a plurality of resist chambers, the substrate processing can be executed while the solvent is stably supplied.

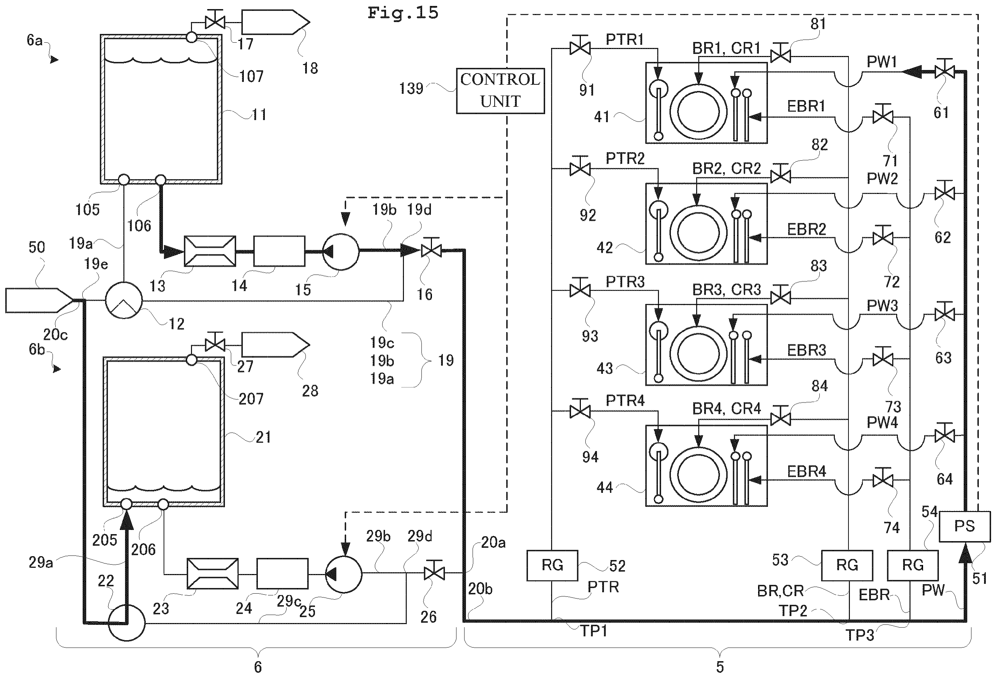

For example, as described in FIG. 15, when one resist chamber 41 among the four resist chambers 41, 42, 43, and 44 causes the solvent to flow through the pre-wet branch pipe PW1 while the remaining three resist chambers 42, 43, and 44 do not use the solvent because the remaining three resist chambers 42, 43, and 44 are transferring the substrate W, the pressure sensor 51 is likely to detect a high pressure. This is because merely a small amount of solvent is used in the substrate processing system at this time.

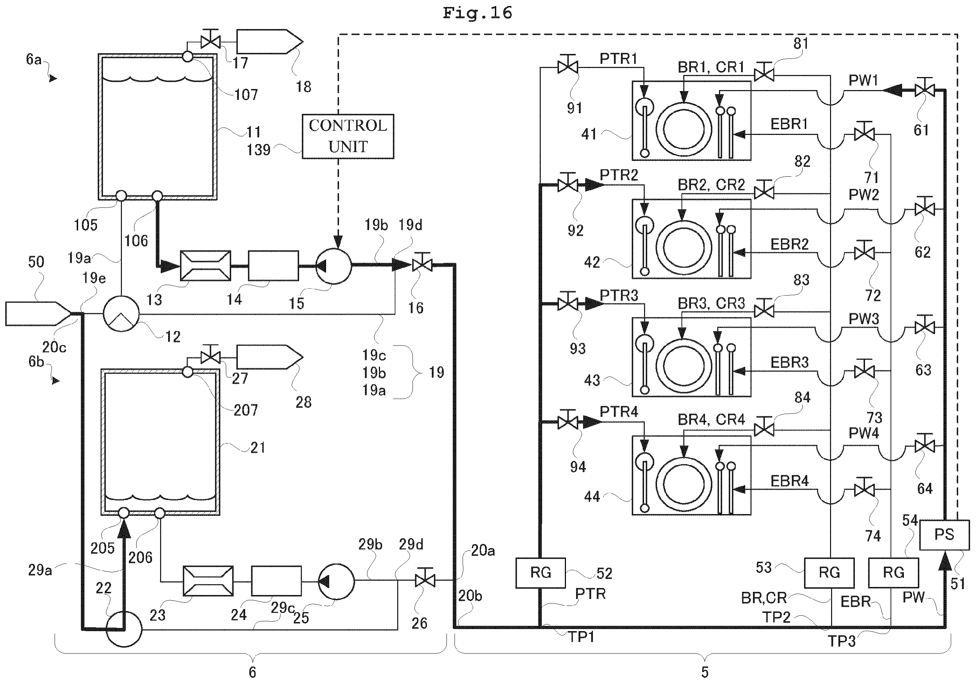

Whereas, as illustrated in FIG. 16, in a state where the resist chamber 41 causes the solvent to flow through the pre-wet branch pipe PW1, and all of the remaining resist chambers 42, 43, and 44 cause the solvent to flow through the pot-rinse branch pipes PTR2, PTR3, and PTR4, the pressure sensor 51 is likely to detect a low pressure. This is because a large amount of solvent is used in the substrate processing system at this time.

In the substrate processing system of the present example, as illustrated in FIG. 16, the feedback control of the pump 15 is performed on the basis of the detection result of the pressure sensor 51, so that the detection result of the pressure sensor 51 has a constant value regardless of the state of the substrate processing system. As described above, according to the present invention, a constant pressure is applied to the pre-wet pipe PW regardless of operating conditions of the resist chambers 41, 42, 43, and 44. This is because the pressure sensor 51 is provided at some midpoint of the pre-wet pipe PW. With this configuration, the substrate processing using the nozzle 10 is performed under an appropriate liquid pressure. This is because the nozzle 10 receives liquid supply from the pre-wet pipe PW. A decrease in the liquid pressure in the pre-wet pipe PW affects the substrate processing. However, according to the present example, since the pressure of the pre-wet pipe PW is appropriate and constant in any case, such a problem does not occur.

### <18. Effects of Present Invention>

According to the configuration described above, the substrate processing apparatus includes the pressure sensor 51 provided in the pre-wet pipe PW and configured to detect a pressure of liquid, and the control unit 139 configured to control the pump 15. The pre-wet pipe PW has a large flow rate of processing liquid, the second diverging pipe represented by the pot-rinse pipe PTR has a small flow rate of processing liquid, and the control unit 139 controls an output of the pump 15 so that the pressure sensor 51 detects a predetermined value. Even if a pressure of liquid in the pre-wet pipe PW decreases due to an increase in a flow of liquid in the pot-rinse pipe PTR, the output of the pump 15 is increased to compensate for the decrease. Since the pre-wet pipe PW requires a large amount of liquid, a high pressure is always required in the pre-wet pipe PW. The configuration described above is a configuration that satisfies such a requirement, and the resist chamber 41 can perform substrate processing under appropriate conditions. With such a configuration, the substrate processing can be reliably executed.

According to the configuration described above, the pre-wet pipe PW is connected to the nozzle 10 that discharges processing liquid to an upper surface of a substrate in the resist chamber 41. The configuration described above allows processing liquid to be supplied at an appropriate pressure to the nozzle 10 requiring a large amount of processing liquid in the resist chamber 41.

According to the configuration described above, the second diverging pipe is the back-rinse pipe BR for cleaning a substrate back surface in the resist chamber 41. As a result, a pressure applied to the nozzle provided in the pre-wet pipe PW does not change depending on the presence or absence of back-rinse processing. With such a configuration, the substrate processing can be reliably executed.

According to the configuration described above, the second diverging pipe is the pot-rinse pipe PTR for nozzle cleaning in the resist chamber 41. As a result, a pressure applied to the nozzle provided in the pre-wet pipe PW does not change depending on the presence or absence of pot-rinse processing. With such a configuration, the substrate processing can be reliably executed.

According to the configuration described above, the second diverging pipe is the edge-rinse pipe EBR for cleaning a substrate peripheral edge in the resist chamber 41. As a result, a pressure applied to the nozzle provided in the pre-wet pipe PW does not change depending on the presence or absence of edge-rinse processing. With such a configuration, the substrate processing can be reliably executed.

According to the configuration described above, since an amount of liquid flowing through the second diverging pipe can be reduced by the regulators 52, 53, and 54, unnecessary consumption of liquid can be reduced.

In the substrate processing apparatus including the plurality of resist chambers 41 as in the present example, the pre-wet pipe PW and the second diverging pipe often allow liquid to flow at the same time. Specifically, examples include a case of performing liquid processing on an upper surface of a substrate using the nozzle 10 in the first resist chamber 41, while performing liquid processing with liquid flowing through the second diverging pipe at the same time in the second resist chamber 41. According to the present invention, the pressure in the pre-wet pipe PW is likely to decrease. Even in the substrate processing apparatus having such a configuration, substrate processing can be executed without the decrease of the pressure of the liquid in the nozzle 10.

As in the present example, in the substrate processing apparatus 1 in which the pre-wet pipe PW as the first diverging pipe is located downstream of the pot-rinse pipe PTR, the back-rinse pipe BR, the cup-rinse pipe CR, and the edge-rinse pipe EBR as the second diverging pipe, in particular, the pressure of the pre-wet pipe is likely to decrease due to the flow of liquid in the pot-rinse pipe PTR, the back-rinse pipe BR, the cup-rinse pipe CR, and the edge-rinse pipe EBR. According to the present invention, since the pressure of the pre-wet pipe PW can be reliably made constant by feedback control, such a problem does not occur.

### <19. Modification>

The present invention is not limited to the configuration described above, and can be modified as follows.

### <Modification 1>

Although the degassing chamber 6 in the embodiment includes two degassing devices, the number of degassing devices can be increased or decreased according to application of the degassing chamber 6.

### <Modification 2>

The sensor 14 in the embodiment is not necessarily required for the present invention. When a condition necessary for degassing is known in advance, the condition may be simply reproduced at the time of degassing processing. Therefore, according to the present modification, the degassing chamber 6 can be configured without confirming disappearance of bubbles by the sensor 14.

### <Modification 3>

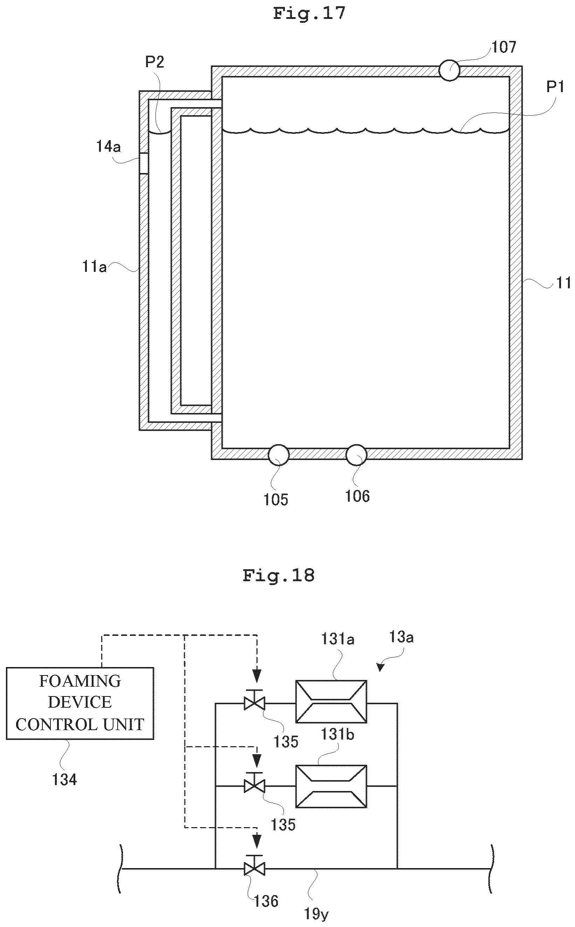

In place of the sensor 14 in the embodiment, the degassing chamber 6 of the present example can also be configured using an electrostatic capacitance sensor that detects a water level of the first tank 11. FIG. 17 illustrates a configuration of the first tank 11 according to the present modification. A liquid guiding pipe 11a extending in the vertical direction is attached to the first tank 11. An upper end and a lower end of the liquid guiding pipe 11a communicate with the first tank 11. Therefore, a height of a liquid level P1 of a solvent stored in the first tank 11 coincides with a height of a liquid level P2 of a solvent guided into the liquid guiding pipe 11a. An electrostatic capacitance sensor 14a is located at some midpoint of the liquid guiding pipe 11a, and is configured to detect the presence or absence of the liquid level P2. When the degassing processing of the solvent stored in the first tank 11 proceeds, bubbles foamed from the liquid are stored in the first tank 11, so that the liquid level P1 of the first tank 11 decreases. Since the liquid guiding pipe 11a communicates with the first tank 11, the liquid level P2 of the liquid guiding pipe 11a also decreases as the liquid level P1 decreases. When the liquid level P2 in the liquid guiding pipe 11a decreases, the electrostatic capacitance sensor 14a detects the decrease in the liquid level P2. Such a detection result of the electrostatic capacitance sensor 14a can be used to determine an end point of the degassing mode in the first degassing device 6a. The electrostatic capacitance sensor 14a may be installed on a side surface of the first tank 11 to directly measure the liquid level P1. In this case, the liquid guiding pipe 11a is not necessarily required.

### <Modification 4>

The foaming device 13 in the embodiment is provided with the needle 133 for control of a foaming state, but the present invention is not limited to this configuration. A foaming device 13a without the needle 133 can also be configured. FIG. 18 illustrates an example of a configuration according to the present modification. The foaming device 13a of the present modification includes a plurality of bases 131a and 131b, and diameters of passages through which the solvent passes in the central portion CT are different between the bases 131a and 131b. For example, when the solvent is made to pass through the base 131a, the degassing processing of the solvent can be performed with the solvent passing through a wide passage. In addition, for example, when the solvent is made to pass through the base 131b, the degassing processing of the solvent can be performed with the solvent passing through a narrow passage. The switching of the base used for the degassing processing is achieved by switching an opening and closing state of a valve 135 attached to each base. The foaming device control unit 134 is configured to control opening and closing of the valve 135.

### <Modification 5>

As illustrated in FIG. 18, a bypass passage 19y that does not include the bases 131a and 131b may be provided. The bypass passage 19y is a flow path for short-circuiting the solvent introduction port and the solvent release port in the foaming device 13 of the embodiment or the foaming device 13a described above. By providing such a bypass passage 19y, the solvent can be quickly made to flow out to each of the resist chambers 41, 42, 43, and 44 in the liquid supply mode of the degassing device. At this time, since flowing of the solvent is not hindered by the foaming device 13, a load of the pump 15 in the liquid supply mode is minimized.

### <Modification 6>

In the configuration of the embodiment, the needle 133 is not adjusted in the degassing mode, but the needle 133 may be operated during the degassing mode. For example, as degassing processing of the solvent in the degassing mode proceeds, the foaming device 13 that has been in a fully opened state may be gradually brought into a fully closed state. With such a configuration, it is possible to reliably perform degassing on the solvent that becomes difficult to foam as the degassing processing proceeds. Further, for example, as degassing processing of the solvent in the degassing mode proceeds, the foaming device 13 that has been in the fully closed state may be gradually brought into the fully opened state. With such a configuration, it is possible to increase a flow rate of the solvent passing through the foaming device 13 over time, and to perform efficient degassing.

The foaming device control unit 134 of the present modification is configured to control the needle 133 to adjust a cross-sectional area of a flow path in the central portion CT as the degassing processing proceeds.

### <Modification 7>

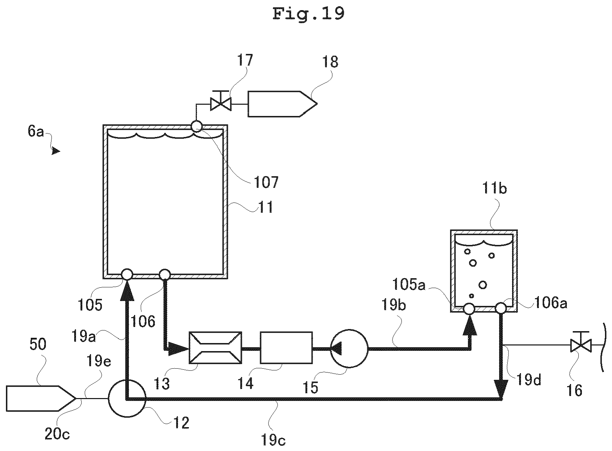

In addition to the configuration of the embodiment, as illustrated in FIG. 19, a trap tank 11b for collecting bubbles may be provided downstream of the foaming device 13 in the first degassing device 6a. The trap tank 11b includes an inflow port 105a and an outflow port 106a at the bottom, the inflow port 105a is connected to the outflow pipe 19b, and the outflow port 106a is connected to the return pipe 19c. The solvent containing bubbles and passing through the outflow pipe 19b reaches the trap tank 11b through the inflow port 105a. In the trap tank 11b, the solvent and the bubbles are separated. The solvent from which the bubbles have been removed flows out of the trap tank 11b through the outflow port 106a, and returns to the first tank 11 through the return pipe 19c. With this configuration, bubbles of the solvent can be reliably removed. The present modification can also be applied to the second degassing device 6b.

### <Modification 8>

Although a shape of the base 131 in the embodiment is straight, the present invention is not limited to this configuration. The base 131 may be an elbow type.

### <Modification 9>

Although a cross-sectional shape of the central portion CT in the embodiment is tapered, the present invention is not limited to this configuration, and a configuration having a flow path in which an inner diameter of the central portion CT is constant can be adopted.

### <Modification 10>

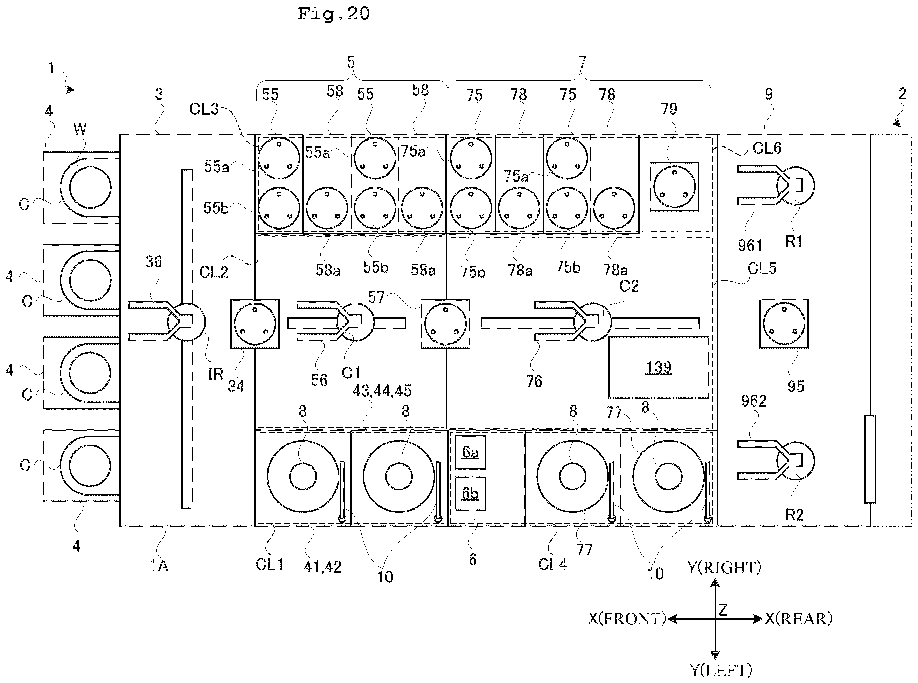

The degassing device having the configuration described above is provided in the coater block 5 and is configured to supply liquid to the resist chambers 41, 42, 43, and 44, but the present invention is not limited to this configuration. As illustrated in FIG. 20, the degassing device may be provided in the developer block 7. The degassing chamber 6 of the present modification is disposed in the fourth row CL4 having the development chamber 77 in the developer block 7. The degassing chamber 6 of the present modification is configured to supply a developer to the development chamber 77.

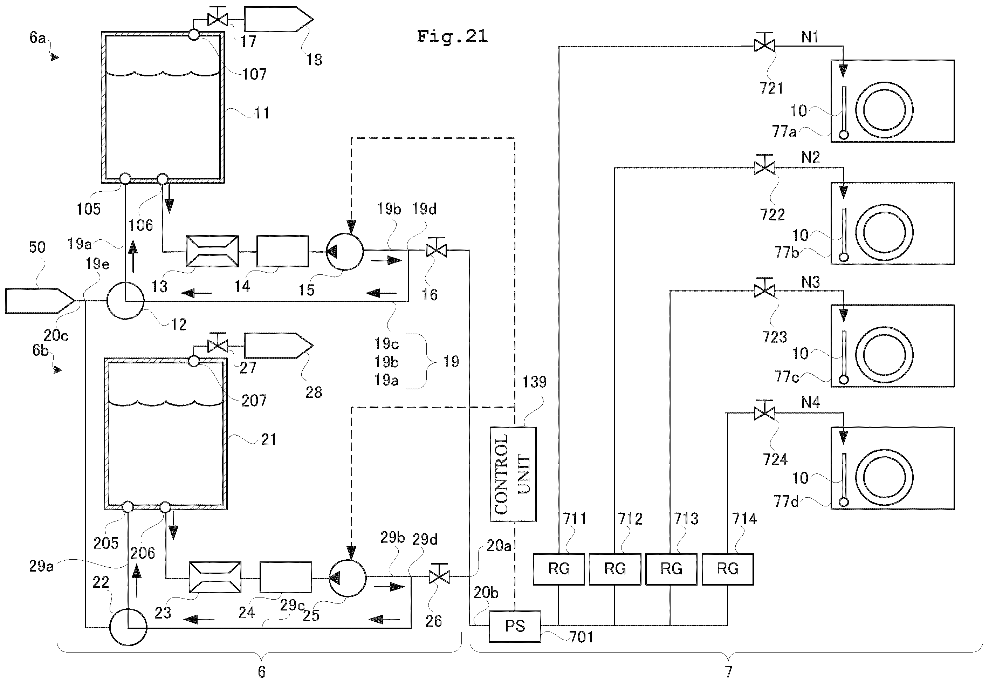

FIG. 21 illustrates a configuration of the degassing chamber 6 and a state in which the degassing chamber 6 is connected to pipes of development chambers 77a, 77b, 77c, and 77d. As described above, the developer block 7 is provided with the four development chambers 77a, 77b, 77c, and 77d, and these are individually operated to simultaneously perform development processing on four substrates W at the maximum.

As illustrated in FIG. 21, since the configuration of the upstream side of the merging pipe 20b is the same as the configuration of the embodiment described in FIG. 2, a detailed description thereof will be omitted.

According to the present modification, a pressure sensor 701 is provided downstream of the merging pipe 20b. The pressure sensor 701 has the same configuration as the pressure sensor 51 of the embodiment, and measures a pressure applied to a developer reaching a regulator 711. In addition to the regulator 711, a regulator 712, a regulator 713, and a regulator 714 are connected in parallel downstream of the pressure sensor 701.

The regulator 711 and the like are provided at some midpoint of the pipes, and can control a pressure of a developer downstream. This point is the same configuration as the regulator 52 and the like of the embodiment.

A primary side of the regulator 711 is connected to the pressure sensor 701, while a secondary side is connected to the nozzle 10 of the development chamber 77a. The developer having passed through the regulator 711 is supplied to the nozzle 10 through a developer pipe N1. A valve 721 is provided on the secondary side of the regulator 711 and at some midpoint of the developer pipe N1. The valve 721 is a control valve for selecting whether or not to discharge the developer from the nozzle 10.

A primary side of the regulator 712 is connected to the pressure sensor 701, while a secondary side is connected to the nozzle 10 of the development chamber 77b. The developer having passed through the regulator 712 is supplied to the nozzle 10 through a developer pipe N2. A valve 722 is provided on the secondary side of the regulator 712 and at some midpoint of the developer pipe N2. The valve 722 is a control valve for selecting whether or not to discharge the developer from the nozzle 10.

A primary side of the regulator 713 is connected to the pressure sensor 701, while a secondary side is connected to the nozzle 10 of the development chamber 77c. The developer having passed through the regulator 713 is supplied to the nozzle 10 through a developer pipe N3. A valve 723 is provided on the secondary side of the regulator 713 and at some midpoint of the developer pipe N3. The valve 723 is a control valve for selecting whether or not to discharge the developer from the nozzle 10.

A primary side of the regulator 714 is connected to the pressure sensor 701, while a secondary side is connected to the nozzle 10 of the development chamber 77d. The developer having passed through the regulator 714 is supplied to the nozzle 10 through a developer pipe N4. A valve 724 is provided on the secondary side of the regulator 714 and at some midpoint of the developer pipe N1. The valve 724 is a control valve for selecting whether or not to discharge the developer from the nozzle 10.

According to the present modification, degassing of the developer can be reliably executed. In addition, according to the present modification, since the plurality of degassing devices are provided, one degassing device can be set to the liquid supply mode while another degassing device is set to the degassing mode, which can inhibit interruption of supply of the developer by the degassing processing.

## Claims

1. A substrate processing apparatus comprising:
a chamber (41) configured to perform liquid processing on a substrate in a horizontal orientation;
a tank (11) configured to store processing liquid;
a main pipe (19b) configured to allow processing liquid to flow from the tank (11);
a pump (15) provided on the main pipe (19b) and configured to feed processing liquid;
a plurality of diverging pipes (PW) formed by branching of the main pipe (19b) downstream of the pump (15), and configured to deliver processing liquid to a plurality of types of processing units in the chamber (41); and
a control unit (139) configured to control the pump (15),
wherein the plurality of diverging pipes (PW) include a first diverging pipe (PW) having a largest flow rate of processing liquid and a second diverging pipe (PTR) having a flow rate of processing liquid smaller than the flow rate of the first diverging pipe (PW),
a pressure gauge (51) configured to detect a pressure of processing liquid is provided in the first diverging pipe (PW) among the plurality of diverging pipes (PW), and
the control unit (139) controls an output of a pump (15) to allow the pressure gauge (51) to detect a predetermined value.

2. The substrate processing apparatus according to claim 1, wherein the first diverging pipe (PW) is connected to a nozzle that discharges processing liquid to an upper surface of a substrate in the chamber (41).

3. The substrate processing apparatus according to claim 1, wherein the second diverging pipe (PTR) is a back-rinse pipe for cleaning a substrate back surface in the chamber (41).

4. The substrate processing apparatus according to claim 1, wherein the second diverging pipe (PTR) is a pot-rinse pipe for nozzle cleaning in the chamber (41).

5. The substrate processing apparatus according to claim 1, wherein the second diverging pipe (PTR) is an edge-rinse pipe for cleaning a substrate peripheral edge in the chamber (41).

6. The substrate processing apparatus according to claim 1, wherein the second diverging pipe (PTR) includes a regulator configured to reduce a pressure of liquid.

7. The substrate processing apparatus according to claim 1, comprising a plurality of chamber (41)s.

8. The substrate processing apparatus according to claim 1, wherein the first diverging pipe (PW) is located downstream of the second diverging pipe (PTR).

9. A control method of a substrate processing apparatus including: a chamber (41) configured to perform liquid processing while rotating a substrate in a horizontal orientation; a tank (11) configured to store liquid; a main pipe (19b) configured to allow liquid to flow from the tank (11) to the chamber (41); a pump (15) provided on the main pipe (19b) and configured to feed liquid; a first diverging pipe (PW) and a second diverging pipe (PTR) that are formed by branching of the main pipe (19b) downstream of the pump (15) and are individually connected to the chamber (41); and a pressure gauge (51) provided in the first diverging pipe (PW) and configured to detect a pressure of liquid,
the control method comprising:
performing feedback control on the pump (15) based on a detected pressure of liquid.
